Europäisches Patentamt

European Patent Office

Office européen des brevets

(11) Publication number: 0 348 085
A1

# EUROPEAN PATENT APPLICATION

(21) Application number: 89305924.6

(51) Int. Cl.⁴: C23C 14/56 , C23C 14/24 , B03C 3/00

(22) Date of filing: 12.06.89

(30) Priority: 21.06.88 JP 152859/88
10.11.88 JP 284457/88

(43) Date of publication of application:
27.12.89 Bulletin 89/52

(84) Designated Contracting States:
DE FR GB

(71) Applicant: ANELVA CORPORATION
8-1 Yotsuya 5-chome
Fuchu-shi Tokyo 183(JP)

(72) Inventor: Aketagawa, Kenichi c/o Anelva
Corporation
8-1 Yotsuya 5-chome
Fuchu-shi 183 Tokyo(JP)
Inventor: Sakai, Junro c/o Anelva Corporation
8-1 Yotsuya 5-chome
Fuchu-shi 183 Tokyo(JP)

(74) Representative: Crisp, David Norman et al
D. YOUNG & CO. 10 Staple Inn
London, WC1V 7RD(GB)

(54) Vacuum deposition apparatus.

(57) The disclosed vacuum evaporation apparatus has a vacuum evaporation chamber (9) provided therein with a dust collector electrode(s) (2, 3) and optionally with an electron beam source (103). When a DC voltage is applied to the dust collector electrode(s), large polarized dust particles and molecular clusters present in an area of the chamber are attracted to the dust collector electrode(s) by virtue of an electric force allowing a deposited film to be formed with a decreased number of surface defects. The electron beam source, if present, serves to electrify or ionize only dust particles and molecular clusters having a large scattering cross section.

FIG. 1

EP 0 348 085 A1

## Vacuum Deposition Apparatus

This invention relates to a vacuum deposition apparatus which can form a deposited film. While the present invention is applicable to all types of vacuum deposition apparatus, we refer below to a molecular beam epitaxial growth apparatus as representative of vacuum deposition apparatus.

Conventionally, in order to effect molecular beam expitaxial growth (representaive of vacuum deposition) with as small a number of surface defects as possible, the purity of the material used for crystal growth in a molecular beam source (representative of various primary evaporation sources) is important, and/or an oil free pumping system capable of improving the degree of cleanness inside a molecular beam epitaxial growth chamber is used to create a super high vacuum in which molecular beam epitaxial growth is effected.

In a molecular beam epitaxial growth apparatus in which the above-mentioned conventional techniques are utilized, however, dust particles, molecular clusters (large bunches of molecules, which are often formed when a molecular beam is formed by vacuum evaporation and which move around as such without being divided into individual molecules), and the like cannot be removed from a molecular beam epitaxial growth chamber, even though impurities in the gas itself remaining in the chamber and in the material used for crystal growth can be removed.

In general, dust particles and the like are not easy to remove from an apparatus in which a super high vacuum is maintained. As a result, molecular beam epitaxial growth, using such apparatus, has the disadvantage of being accompanied by the development of a large number of surface defects due to these dust particles and molecular clusters. In particular where a molecular beam source is used as a primary evaporation source (evaporation source to be used for film formation) and is combined with another molecular beam source as a secondary evaporation source (evaporation source to be used for doping) and a DC voltage is applied between the secondary evaporation source and a substrate to increase the efficiency of doping with an impurity or dopant, the dopant being contributory to electric conduction through a crystalline (single crystal or polycrystalline) film form, the number of surface defects in the film has been found to notably increase. Thus, a measure against such a tendency has been in a serious demand.

It is known in conventional apparatus for some purposes, such as those used in an ion plating process disclosed in Japanese Patent Publication No. 57,553/1982, to have a chamber provided with an electrode to which a high voltage is applied. In all such apparatus, however, the voltage is applied to cause discharge in order to effect ionization of molecules. It is not known to apply a voltage for the purposes of dust collection.

The present invention seeks to provide a solution for the above-mentioned problems and provide a vacuum deposition apparatus capable of forming a high-quality deposited film while strongly suppressing the influence of dust particles and molecular clusters, and particularly to provide a molecular beam epitaxial growth apparatus which permits a DC voltage to be applied between a substrate and a secondary molecular beam source (as well as other parts with the same electric potential as that of the secondary molecular beam source, including the wall of a molecular beam epitaxial growth chamber) without the incurrence of any substantial increase in the number of surface defects in the film being deposited.

According to the present invention, there is provided a vacuum deposition apparatus comprising a vacuum deposition chamber provided therein with at least one dust collector electrode between which and an evaporation source a high DC voltage is applied in use to give said dust collector electrode an electric force by which dust particles and molecular clusters are removed from at least a part of said vacuum deposition chamber. Preferably, the apparatus includes an electron beam source is used to irradiate a space in the proximity of the dust collector electrode with an electron beam emitted therefrom.

A dust collector electrode located in a position so as not to prevent a vapor emitted from an evaporation source from moving towards a substrate, not only allows uniformity of vacuum deposition on the substrate to be achieved, but also gives very little defective vacuum deposition if a high DC voltage is applied to the substrate during vacuum deposition.

When there is no electrode beam irradiation from an electron beam source, free dust particles and molecular clusters in amolecular beam epitaxial growth chamber are polarized by a strong electric field created by the dust collector electrode. When the electric field has a gradient, only dust particles and molecular clusters which are larger than molecules are charged by the difference in the electric field and they become receptive to the force created by the gradient of the electric field intensity (gradient force of electric field). As a result, dust particles and molecular clusters are removed from a molecular beam directed towards a substrate. The inventors believe this serves to decrease the number of surface defects of a film vacuum-deposited on the substrate.

On the other hand, where there is electron bean irradiation from an electron beam source, only free dust particles and molecular clusters with a larger scattering cross-section in a molecular beam crystal growth chamber are charged or ionized upon irradiation with the electron beam. Only harmfully charged or ionized dust particles and molecular clusters with a certain or large size are removed from a molecular beam directed towards a substrate. This mechanism is also believed to decrease the number of surface defects in a film vacuum-deposited on the substrate.

Preferred features and embodiments of the invention will now be described by way of non-limiting example with reference to the following accompanying drawings, in which:

Fig. 1 is a front cross-sectional view of an example of a molecular beam epitaxial growth apparatus according to one embodiment of the present invention, comprising a dust collector electrode, a molecular beam source, and a substrate;

Fig. 2 is a perspective view of the principal components of the embodiment of Fig. 1;

Fig. 3 is a partial cross-sectional view along line A-A of Fig. 1;

Figs. 4 and 5 show various positions adopted by a dust collector electrode in order to find the relationship between the position of the dust collector electrode and the number of surface defects;

Figs. 6(a) to 6(h) show various shapes of dust collector electrodes;

Fig. 7 is a diagram showing the relationship between the position of a dust collector electrode and the number of surface defects; and

Fig. 8 is a diagram showing the relationship between the voltage applied to a dust collector electrode and the number of surface defects.

A molecular beam epitaxial growth chamber 9 (hereinafter referred to simply as a "chamber") has a wall, which is provided with an observation window 10.

A molecular beam 4 emitted from a molecular beam source 1 heated with an electrode gun (not shown in the figures) is directed towards a substrate 6. The molecular beam can be shut off by closing a shutter 5 (in the figures, the shutter 5 is shown opened). The chamber 9 and the molecular beam source 1 are both earthed.

A positive or negative DC voltage $\dot{V}31$ can be applied from a DC source 31 located outside the chamber 9 to the substrate 6 which is electrically insulated from the chamber 9 with an insulator 30.

A dust collector electrode, according to one embodiment of the present invention, comprises two needle-like electrode parts 2 and a plate electrode part 3 which are electrically connected with each other. The dust collector electrode is electrically insulated from the chamber 9 with an insulator 20. A high positive or negative DC voltage V21 can be applied from a high-voltage DC power source 21 located outside the chamber 9 to the dust collector electrode.

A molecular beam source 8, capable of generating a molecular beam by a resistance heating system, is provided as an adjutant one (secondary molecular beam source) in some embodiments where the molecular beam source 1 is used as the primary molecular beam source. In other embodiments, however, the molecular beam source 8 may be inversely used as the primary molecular beam source. A shutter 7 is provided which may be used to shut out a molecular beam emitted from the secondary molecular beam source 8. The secondary molecular beam source 8 is at the same electric potential as the wall of the chamber.

An electron beam irradiation unit 100 is provided and comprises a filament 103 which serves as an electron beam source. An electric current flows from a grounded low-voltage DC power source 101 on the side of the atmosphere through a wiring running through an insulator 102, provided in part of the chamber wall, to the filament 103 in order to heat the filament 103 up to an incandescent state, in which state an electron beam is emitted from the filament 103. A space in the proximity of the dust collector electrode with the electrode parts 2 and 3 is irradiated with the electron beam.

The following description of the present invention will be divided into one embodiment where the electron beam irradiation unit 100 is used and another embodiment where the electron beam irradiation unit 100 is not used.

The operation of preferred embodiments of the present invention will be described with reference to the deposition of an epitaxially grown silicon film on a Si substrate 6.

In one embodiment, Si for epitaxial growth is filled or placed in the molecular beam source 1. Where antimony is to be doped into a surface portion of the epitaxially grown silicon film, antimony is filled or placed in the secondary molecular beam source 8.

As described hereinbefore, a DC voltage may be applied between the secondary molecular beam source 8 (and the wall of the chamber) and the substrate 6 in order to increase the amount of doping.

In order, particularly, to effect crystal growth of ZnS, a resistance heating system may be used in a molecular beam source. An experiment was conducted wherein ZnS (zinc sulfide) as a material for crystal growth was placed in the molecular beam source 8 with the resistance heating system, which was then used as the primary molecular beam source in the experiment. This molecular beam epitaxial growth apparatus was used to carry out an experiment initially without using the electron beam irradiation unit 100.

As a result, it was found that molecular beam epitaxial growth on the surface of a substratre 6 can be effected to give no substantial surface defects when the value of voltage applied to the dust collector electrode with the electrode parts 2 and 3 and the positions of the electrode parts 2 and 3 in relation to the molecular beam 4 are optimized.

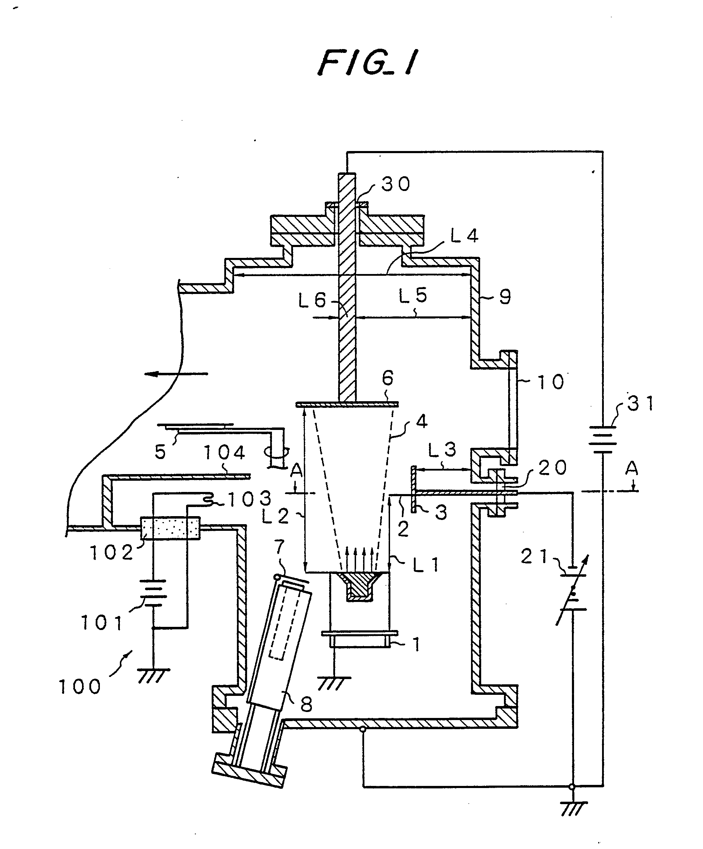

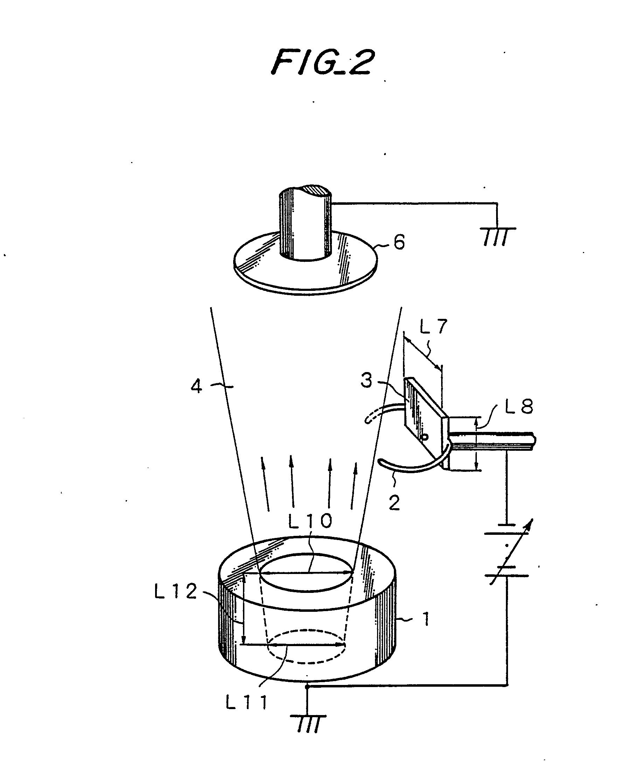

The dimensions of L1 to L12 and R1 (shown in Figs. 1 to 3) in the apparatus used in this experiment were as follows:

L1 = 125, L2 = 250, L3 = 80, L4 = 400 ,L5 = 190,
L6 = 15 , L7 = 80, L8 = 80, L9 = 90, L10 = 40 , L11 = 35 , L12 = 20, R1 = 30. (unit : mm)

The Si molecular beam source 1 was heated with a 10 kW electron gun at an acceleration voltage of 10 kV to effect Si molecular beam epitaxial growth on the surface of a Si substrate 6 of 4 inches , while a voltage V31 of zero and a voltage V21 of zero were kept for the Si substrate 6 and the dust collector electrode with the electrode parts 2 and 3, respectively (that is, the earthing voltage was kept for both). The number of surface defects in the resulting epitaxial-grown film was $33/cm^2$.

Molecular beam epitaxial growth was effected under substantially the same conditions as described above except that the voltage V21 applied to the dust collector electrode with the electrode parts 2 and 3 made of Ta was changed to -5 kV. The number of surface defects in the resulting epitaxial-grown film was $0/cm^2$. In other words, the film had a perfectly defect-free surface. The rate of crystal growth was the same as in the preceding case.

Such a good result can not be obtained using conventional molecular beam epitaxial growth apparatuses.

In addition, the high voltage V21 of -5 kV exerted no influence on an electric field created by the electron gun for the molecular beam source 1.

Whilst not wishing to be bound by theoretical considerations, we have proposed two theories for the above-mentiond result. One theory is that an electric field created by the electrode parts 2 and 3 of the dust collector electrode polarizes dust particles, molecular clusters and the like in a space in the chamber. Those dust particles, molecular clusters and the like with a certain or larger size are collected on the electrode parts 2 and 3 of the dust collector electrode by means of the so-called gradient force of the electric field. The other theory is that only those particles electrified or ionized with the electron gun deviate from the main stream of the molecular beam (repelled by virtue of the polarity of the particles) and move towards the electrode parts 2 and 3 of the dust collector electrode, and do not reach the substrate, thus enabling crystal growth to be effected without lowering the rate thereof and with no surface defects in the resulting epitaxial-growth film.

The theory that the strong electric field acts on dust particles and molecular clusters to favourably affect the number of surface defects was found to be supported by the following experiments.

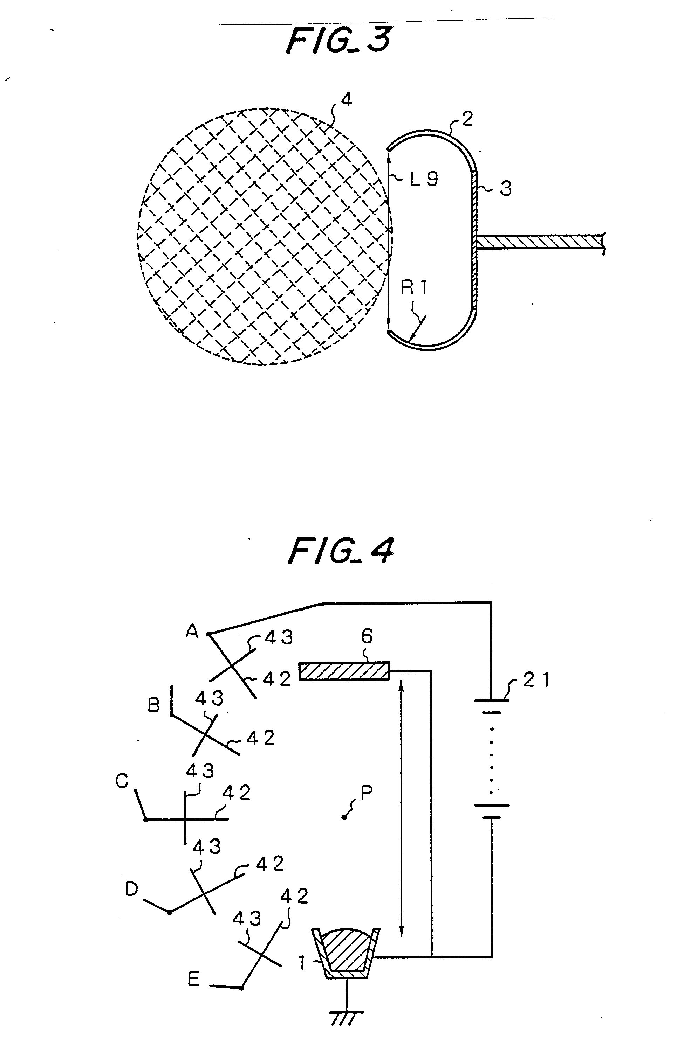

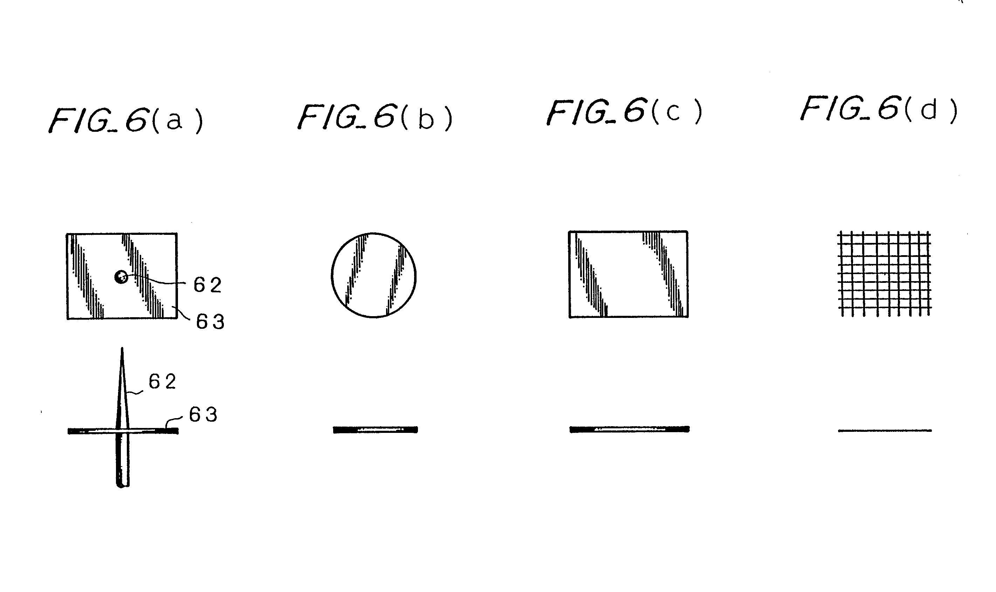

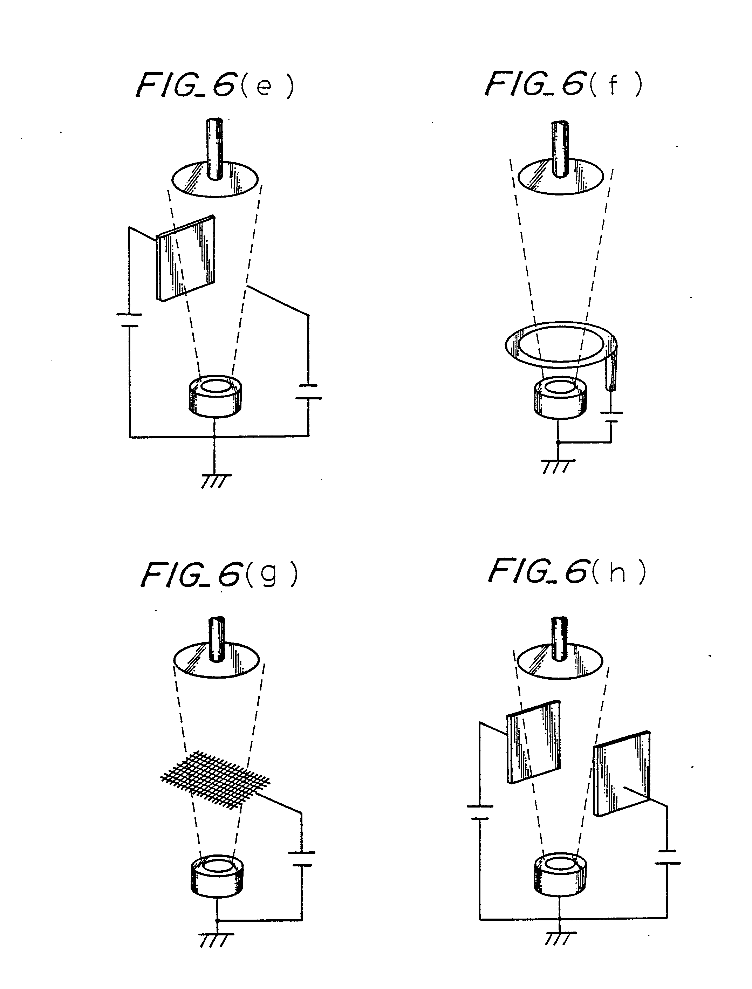

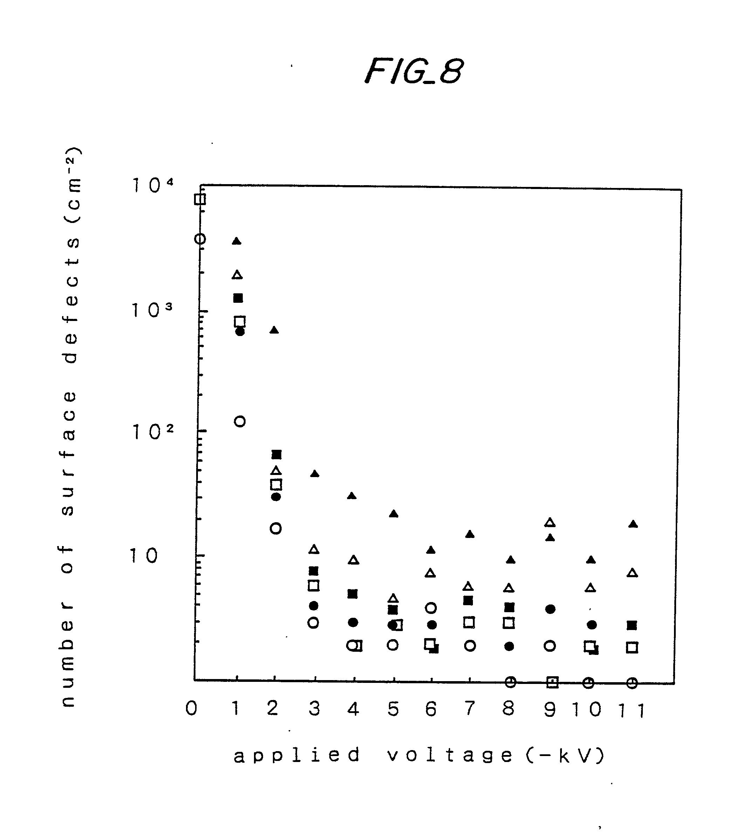

Firstly, the dust collector electrode was replaced with one having electrode parts 62 and 63 as shown in Fig. 6(a), which was fixed in a position C as shown in Fig. 4. The relationship between the applied voltages V21 and V31 and the number of surface defects was examined. The results are shown in Fig. 8. In this experiment, the output of the electron gun was controlled so as to provide a crystal growth rate of 2 Å /sec.

The marks ● refer to cases where a voltage negative relative to the potential of the molecular beam source was applied to the dust collector electrode.

The marks O refer to cases where a voltage positive relative to the potential of the molecular beam source was applied to the dust collec tor electrode.

The marks ▲ refer to cases where a voltage negative relative to the potential of the molecular beam source was applied to the dust collector electrode while a voltage of +600 V was applied to a substrate.

The marks △ refer to cases where a voltage positive relative to the potential of the molecular beam source was applied to the dust collector electrode while a voltrage of +600 V was applied to a substrate.

The marks ■ refer to cases where a voltage negative relative to the potential of the molecular beam source was applied to the dust collector electrode while a voltage of -600 V was applied to a substrate.

The marks □ refer to cases where a voltage positive relative to the potential of the molecular beam source was applied to the dust collector electrode while a voltage of -600 V was applied to a substrate.

With a voltage of a mere 3 to 4 kV applied to the dust collector electrode with the electrode parts 62 and 63, the number of surface defects was decreased to less than 1/1,000 of that in the case of no voltage application to the dust collector electrode, thus proving that this embodiment of the invention can product a sufficient effect.

In addition, with the application of voltage of up to 8 kV, an electric current of about 2 mA flowed between the dust collector electrode and the vaporation source (namely earth or ground), though it varied slightly in proportion to the output of the electron gun.

Upon application of a voltage exceeding 8 kV, discharge occurred in some cases, as a result a higher voltage, could not be applied to the dust collector electrode.

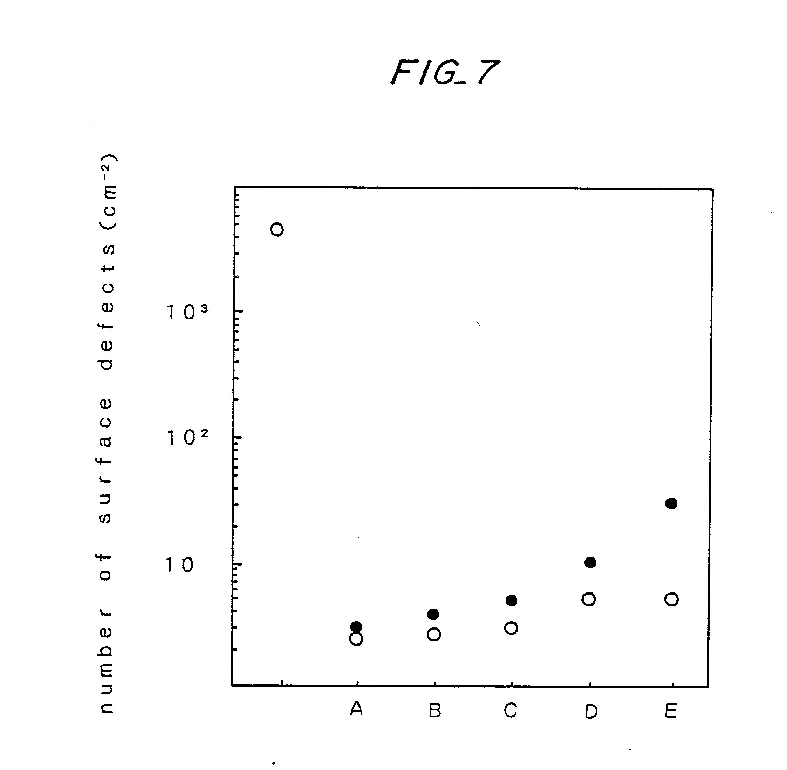

Experiments were also carried out, in which the position of the dust collector electrode was varied in the same chamber. As shown in Fig. 4, the tip of the needle-like electrode part 42 was pointed at the middle point P of the line connecting the substrate with the molecular beam source with a distance of 125 mm between the middle point P and the tip of the needle-like electrode part 42 to which a high voltage was applied. While maintaining these conditions the dust collector electrode with the electrode parts 42 and 43 was located in turn in the positions A, B, C, D and E with the height of the position C being 125 mm from a crucible of the molecular beam source and with an angular interval of about 30° between mutually nearest positions (the position A alone being located slightly backward to avoid collision of the dust collector electrode against the substrate) to carry out an experiment, which provided experimental data as plotted in Fig. 7 to show the relationship between the number of surface defects and the position of the dust collector electrode. A voltage of +3 kV or -3 kV was applied to the dust collector electrode with the electrode parts 42 and 43 to examine the performance thereof.

When no dust collector electrode was used (designated by the word "none" in Fig. 7), the number of surface defects was about 3,800/cm², whereas the use of the dust collector electrode in every one of those positions gave a reduced number of surface defects. However, the results obtained were comparatively better as the dust collector electrode was located nearer to the position of substrate 6.

Application of either positive or negative bias voltage to the dust collector electrode had the effect of reducing the number of surface defects.

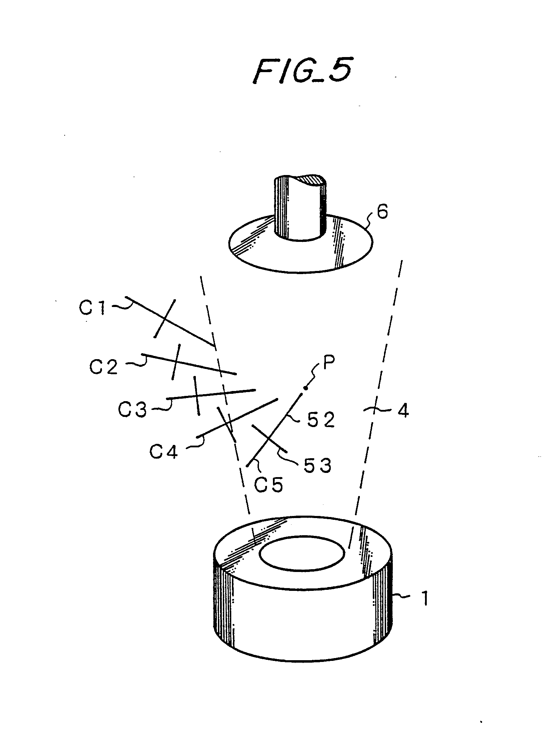

Similarly, as shown in Fig. 5, the distance of the tip of the needle-like electrode part 52 of the dust collector electrode from the middle point P of the flight route of molecular beam was varied with the height of the dust collector electrode being kept at 125 mm from the molecular beam source to carry out an experiment, which gave the results shown in Table 1.

Table 1

| Distance from P | | Number of Surface Defects(/cm²) | | Uniformity of Film Thickness |
|---|---|---|---|---|
| | | +3kV | -3kV | |
| C1 | 150 | 12 | 30 | ±2%≧ |
| C2 | 125 | 3 | 5 | ±2%≧ |
| C3 | 75 | 3 | 3 | ±2%≧ |
| C4 | 25 | 2 | 3 | ±5%≧ |
| C5 | 0 | 3 | 2 | ±5%≧ |

Although no marked differences appeared between the results of this experiment, the tendency was such that the number of surface defects was larger the further apart the dust collector electrode was from the molecular beam. This is suggestive of collection by the dust collector electrode of dust particles and molecular clusters within the molecular beam. In addition, when the dust collector electrode was located in the molecular beam, the uniformity of the thickness of the film formed was worse than that attained when the dust collector electrode was located outside the molecular beam.

Table 2 shows results obtained from an experiment which compares using an electron gun to using a resistance heating system. In this experiment, ZnS (zinc sulfide) was used as a material for crystal growth to be placed in the molecular beam sources. The electron gun was used in combination with the molecular beam source 1 as shown in Fig. 1 as a primary molecular beam source, while the resistance heating system was used in combination with the molecular beam source 8 .as shown in Fig. 1 as a primary molecular beam source. In the case of both the electron gun and the resistance heating system, the dust collector electrode was located in the position C as shown in Fig. 4.

Table 2

| Number of Surface Defects(/cm$^2$) | | | |
|---|---|---|---|
| Conditions | | Electron Gun | Resistance Heating |
| Dust Collector Electrode | 0V | 2800 | 500 |
| Dust Collector Electrode<br>Substrate +600V | 0V, | 4200 | 1800 |
| Dust Collector Electrode<br>Substrate -600V | 0V, | 3600 | 1600 |
| Dust Collector Electrode | +3kV | 8 | 20 |
| Dust Collector Electrode | -3kV | 10 | 15 |
| Dust Collector Electrode<br>Substrate +600V | +3kV, | 15 | 10 |
| Dust Collector Electrode<br>Substrate +600V | -3kV, | 12 | 20 |
| Dust Collector Electrode<br>Substract +600V | +3kV, | 19 | 10 |
| Dust Collector Electrode<br>Substrate -600V | -3kV, | 8 | 9 |

The results indicate that the effect of the dust collector electrode is very great no matter which of the mechanisms is used to form a molecular beam. The reason for the development of a particularly large number of surface defects in the case of using the electron gun without using the dust collector electrode is believed to be that some dust particles attracted to the material by an electric field created by the electron gun might cause the formation of additional molecular clusters and these and other dust particles may then form part of the molecular beam.

The dependency of the number of surface defects on the shape of dust collector electrode(s) was examined both in the case of using an electron gun in continuation with a molecular beam source and in the case of using a resistance heating system in combination with a molecular beam source.

Use was made of various dust collector electrodes having the respective shapes shown in Figs. 6(a), 6-(b), 6(c), 6(d), 6(e), 6(f), 6(g), and 6(h). Each one of the dust collector electrodes shown in Figs. 6(a), 6(b), 6-(c) and 6(d) was fixed inthe position C as shown in Fig. 4, while each one or set of the dust collector electrodes shown in Figs. 6(e), 6(f), 6(g) and 6(h) was fixed in the respective position(s) mentioned in Table 3 and shown in Table 6. A voltage of +3 kV was applied thereto. No bias voltage was applied to a substrate. The result sof examination of the number of surfacer defects are shown in Table 3.

6

Table 3

| Shape of Dust Collector Electrode(s) | | Number of surface Defects(/cm²) | |
|---|---|---|---|
| | | Electron Gun | Resistance Heating |
| No Electrode | | 3420 | 680 |
| Electrode with rectangular plate and needle-like electrode parts | Fig.6(a) | 5 | 15 |
| Disc Electrode | Fig.6(b) | 6 | 120 |
| Rectangular Electrode | Fig.6(c) | 8 | 98 |
| Gauze Electrode | Fig.6(d) | 8 | 8 |
| Rectangular plate electrode and needle-like electrode (note 1) | Fig.6(e) | 10 | 30 |
| Ring Electrode (Note 2) | Fig.6(f) | 25 | 372 |
| Gauze Electrode Disposed in Molecular beam | Fig.6(g) | 7 | 7 |
| Two Parallel flat electrodes disposed so as to sandwich molecular beam | Fig.6(h) | 6 | 296 |

(Note 1) The two electrodes were disposed so as to sandwich a moleular beam while voltages of + 1.5 kV and -1.5 kV were applied to the needle-like electrode and the rectangular plate electrode, respectively.

(Note 2) The dust collector electrode was disposed just above a crucible in such a way to surround a molecular beam with the ring thereof.

Particularly in the case where the gauze electrode shown in Fig. 6(g) was disposed in the molecular beam, the rate of epitaxial growth was low and the uniformity of the film thickness was very bad. Apart from this, a decrease in the number of surface defects was achieved with each shape(s) of dust collector electrode(s). In each case, it was found that the use of the electron gun provided a far superior effect with the dust collector electrode to the use of the resistance heating system. However, in the case of using the resistance heating system for the molecular beam source, the results indicate that adoption of any angular shape for a dust collector electrode might be more effective. The reason for this is believed to be that a steep gradient of electric field intensity created around the shape portion of a dust collector electrode might work advantageously. The fact that the set of two parallel flat plate electrodes (Fig. 6(h) used to create a uniform electric field exhibited comparatively little reduction in surface defects may be supportive of the aforementioned model that dust particles and molecular clusters with a certain or larger size in relation to the size of molecules are more strongly effected by a gradient of electric field.

An experiment was carried out on whether or not a dust collector electrode may exert an influence on the efficiency of dopant doping.

In conventional methods of doping with a substance having a low sticking coefficient such as Sb, use is made of a method in which a voltage is applied to a substrate to pull into the substrate Si ions formed by ionization of Si with electrons emitted from an electron gun type evaporation source so that the Si ions can assist Sb absorbed on the surface of the substrate to be injected into the substrate. Use is also made of a method wherein an ionization mechanism is provided in an upper portion of a resistance heating type molecular beam source for the dopant Sb in order to decompose part of the Sb molecules into Sb ions. Therefore, experiments using the above-mentioned two respective methods were carried out in respect of embodiments of the present application.

The apparatus of Fig. 1 was used, except that a dust collector electrode having a shape as shown in Fig. 6(a) was located in the position C as shown in Fig. 4. A voltage of + 3 kv or -3kv was applied to the dust collector electrode. The molecular beam source 1 was heated with the electron gun. A dopant (impurity) was placed in the resistance heating type molecular source 8. The carrier density was determined by utilizing the Hall Effect at room temperature. The dopant was antimony (Sb), which is an n-type dopant. The results are shown in Table 4.

Table 4

| Dopant | Conditions | | Number of Surface Defects | Carrier Density $(cm^{-3})$ |
|---|---|---|---|---|
| | Dust Collector Electrode | Substrate | | |
| Sb | OV OV | 3100 | $1.0 \times 10^{16}$ | |
| | OV -400V | 3300 | $1.5 \times 10^{18}$ | |
| | +3kV | -400V | 4 | $1.7 \times 10^{16}$ |
| | -3kV | -400V | 10 | $1.5 \times 10^{16}$ |

The results in Table 4 show that the amount of doping is decreased when a high voltage is applied to a dust collector electrode. The reason for this is believed to be that some of the ions used to assist doping might be affected by the dust collector electrode and to fail to reach the substrate.

In view of the above results, a resistance heating type molecular beam source with an ionization mechanism was prepared. The ionization mechanism is attached to the top of the molecular beam source, and comprises a filament and a grid. Electrons emitted from the filament are accelerated by an electric field created between the filament and the grid. Molecules receive the impact of the accelerated electrons and are ionized. The ionization mechanism is hereinafter referred to as a "ionization molecular beam source". The ionization molecular beam source was disposed nearer to the substrate than to the dust collector electrode. The influence of the dust collector electrode on impurity doping was examined. The results are shown in Table 5.

Table 5

| Dopant | Conditions | | Number of Surface Defects | Carrier Density $(cm^{-3})$ |
|---|---|---|---|---|
| | Dust Collector Electrode | Substrate | | |
| Sb | OV OV | 3100 | $1.0 \times 10^{16}$ | |
| | OV -400V | 3300 | $1.5 \times 10^{18}$ | |
| | +3kV | -400V | 25 | $1.7 \times 10^{18}$ |
| | -3kV | -400V | 10 | $1.5 \times 10^{16}$ |

It can be seen from Table 5 that impurity doping is not affected at all by a collector electrode while the number of surface defects can still be decreased, if a resistance heating type ionization molecular beam source is disposed near to the substrate and the potentials of the dust collector electrode and substrate are chosen suitably.

In every one of the foregoing experiments, a dust-collecting effect of the dust collector electrode could be seen, without slowing down the epitaxial growth, though some differences in the effect were recognised.

As a second effect of the provision of a dust collector electrode, it was visually observed that bumping of vacuum deposition material, which is usually liable to occur in the case of using an electron gun as a molecular beam source, was subdued quickly upon application of a high voltage to the dust collector electrode. This effect indicates that bumping of a vacuum deposition material, which quite often occurs when using an electron gun, is caused by dust particles pulled into the material by an acceleration electric field created by an electron gun. The reduction in bumping is suggestive of a drastic decrease in the number of molecular clusters in a molecular beam.

An experiment similar to that described hereinbefore was carried out using the electron beam irradiation unit 100, namely heating the filament 101 as the electron beam source up to an incandescent state in order to attempt to improve the dust-collecting effect of a dust collector electrode where a resistance heating type molecular beam source is used. This experiment was carried out as it had been found that the use of an electron gun as the molecular beam source enhanced the dust-collecting effect even in cases where a uniform electric field was created with a set of two parallel flat plate electrodes.

A cover 104 was provided just above the filament 103 to cover the filament 103 from a substrate 6 for the purpose of avoiding any damage that might otherwise have been inflicted onto the surface of the substrate by the intense irradiation of the electron beam from the filament 103. The dependency of the number of surface defects on the shape of dust collector electrode was examined both in the case of using the electron beam irradiation unit 100 in combination with the electron gun as well as in the case of using the electron beam irradiation unit 100 in combination with the resistance heating type molecular beam source. Dust collector electrodes each having one of various shapes as shown in Figs. 6(a)-6(h) were preapred. Each one of the dust collector electrodes shown in Figs. 6(a), (b), 6(c) and 6(d) was fixed in the position C as shown in Fig. 4, while each one or set of dust collector electrodes shown in Figs. 6(e), 6(f), 6-(g) and 6(h) was fixed in the respective position(s) as mentioned in Table 6. A voltage of +3 kV was applied thereto. No bias voltage was applied to a substrate. The results are shown in Table 6.

Table 6

| Shape of Dust Collector Electrode | | Number of surface defects(/cm$^2$) | |
|---|---|---|---|
| Electron Gun | Resistance Heating | | |
| No electrode | | 3420 | 680 |
| Electrode with rectangular plate and needle-like electrode parts | Fig.6(a) | 8 | 15 |
| Disc Electrode | Fig.6(b) | 7 | 5 |
| Rectangular Electrode | Fig.6(c) | 10 | 2 |
| Gauze Electrode | Fig.6(d) | 10 | 6 |
| Rectangular plate electrode and needle-like electrode (Note 1) | Fig.6(e) | 9 | 3 |
| Ring Electrode (Note 2) | Fig.6(f) | 22 | 27 |
| Gauze electrode disposed in molecular beam | Fig.6(g) | 6 | 7 |
| Two parallel flat electrodes disposed so as to sandwich molecular beam | Fig.6(h) | 6 | 2 |

(Note 1) The two electrodes were disposed so as to sandwich a molecular beam while voltages of +1.5 kV and -1.5kV were applied to the needle-like electrode and the rectangular plate electrode, respectively.

(Note 2). The dust collector electrode was disposed just over a crucible so as to surround a molecular beam with the ring thereof.

In the experiment, results superior or substantially equal to the respective corresponding results listed in Fig. 3 were obtained in almost all cases. Particularly when the resistance heating type molecular beam source was used as the molecular beam source, the use of the electron beam irradiation unit 100 exhibited obviously better effects than the nonuse thereof.

When a high negative voltage was applied to the dust collector electrode, a reduction in the number of surface defects due to the dust collector electrode was seen, though the degree of the reduction was a little smaller than that in the case of application of the positive voltage to the dust collector electrode.

The mechanism of dust collection in the case of electron beam irradiation from the electron beam source 103 as well as in the case of electron beam irradiation from the electron gun may obviously be different from that in the case of no electron beam irradiation. Specifically, it is believed that electron beam irradiation in these two cases causes electrification or ionization of only dust particles, molecular clusters and the like having a large scattering cross section in an area of the chamber, and among these particularly only those with a certain or large size were than deviated from the path which they would have taken if no dust collector electrode had been provided, and were thus removed from the molecular beam by the dust collector electrode(s) to which a high voltage had been applied.

The vacuum deposition apparatus according to one embodiment of the present invention is provided with at least one dust collector electrode having a simple structure as described hereinbefore, and optionally with an electron beam irradiation unit. A high voltage is simply applied to the at least one dust collector electrode, and optionally a filament in the electron beam irradiation unit, if present, is simply heated. The apparatus is based on a simple mechanism and can be easily utilized not only in molecular beam epitaxial growth appartuses but also a wide variety of other conventional apparatus such as vacuum deposition apparatus for thin film formation to make it possible to form films having a high purity.

Furthermore, dust collector electrodes as mentioned above can be used in vacuum chambers to be used for purposes other than vacuum evaporation and deposition. Since dust and other particles, including considerably large dust particles, in a chamber are collected into one place, apparatus embodying the present invention are easy to maintain.

When use is made of the vacuum depostion apparatus according to embodiments of the present invention, the number of surface defects attributed to dust particles and molecular clusters can be very largely decreased without slowing down the crystal growth and without any influences on the efficiency or impurity of dopant doping.

## Claims

1. A vacuum deposition apparatus comprising a vacuum deposition chamber provided therein with at least one dust collector electrode between which and an evaporation source a high DC voltage is applied in use to give said dust collector electrode an electric force by which dust particles and molecular clusters are removed from at least a part of said vacuum deposition chamber.

2. A vacuum deposition apparatus according to claim 1 further comprising an electron beam source which in use generates an electron beam for irradiating a space in the proximity of said dust collector electrode.

3. A vacuum deposition apparatus according to either of claims 1 and 2, wherein said dust collector electrode is disposed in such a position so as not to prevent vapour emitted from said evaporation source from moving toward a substrate.

4. A vacuum deposition apparatus according to any one of the preceding claims, wherein said high DC voltage is applied to said dust collector electrode during vacuum evaporation and deposition.

5. A vacuum depcsition apparatus according to any one of the preceding claims, wherein said vacuum deposition apparatus is a molecular beam epitaxial growth apparatus provided therein with a primary molecular beam source as said evaporation source and with a secondary molecular beam source between which and a substrate a DC voltage having an opposite polarity to that applied to said dust collector electrode is applied to increase the amount of doping of growing crystals with a dopant substance placed in said secondary molecular beam source.

6. A method for depositing a film on a substrate using an apparatus according to any one of claims 1 to 5.

7. A substrate having a film deposited thereon using a vacuum deposition apparatus according to any one of claims 1 to 5.

8. A vacuum apparatus comprising a vacuum chamber provided therein with at least one dust collector electrode having in use an electric force, generated by a high DC voltage applied to at least said dust collector electrode, by which dust particles and molecular clusters are removed from at least a part of said vacuum chamber.

# FIG_1

# FIG_2

## FIG_3

## FIG_4

# FIG_5

C1
C2
C3
C4
C5
P
52
53
4
6
1

FIG_6(a)  FIG_6(b)  FIG_6(c)  FIG_6(d)

62

63

62

63

EP 0 348 085 A1

## FIG_6(e)

## FIG_6(f)

## FIG_6(g)

## FIG_6(h)

# FIG_7

## FIG_8

**European Patent Office**

# EUROPEAN SEARCH REPORT

Application Number

EP 89 30 5924

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | IBM TECHNICAL DISCLOSURE BULLETIN, vol. 12, no. 1, June 1969, page 149, New York, US; E. STERN: "Reducing dust-induced pinholes in sputtered films" * Whole document * | 1,3,6-8 | C 23 C 14/56 C 23 C 14/24 B 03 C 3/00 |
| A | EP-A-0 161 205 (MITSUBISHI JUKOGYO) * Abstract * | 1,8 | |
| A | WO-A-8 702 597 (LICENTIA PATENTVERWALTUNG) * Abstract * | 2 | |
| A | IEEE SPECTRUM, vol. 17, no. 4, April 1980, pages 18-23, IEEE, New York, US; M.G. PANISH et al.: "Molecular beam epitaxy" * Figure 1 * | 5 | |

**TECHNICAL FIELDS SEARCHED (Int. Cl.4)**

C 23 C
B 03 C

The present search report has been drawn up for all claims

| Place of search | Date of completion of the search | Examiner |
|---|---|---|
| THE HAGUE | 28-09-1989 | PATTERSON A.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)